# FASCICULE DE BREVET EUROPEEN

(11) **EP 3 707 735 B1**
(45) Date de publication et mention de la délivrance du brevet: **30.06.2021**
(21) Numéro de dépôt: 18786845.0
(22) Date de dépôt: 25.09.2018
(51) Int. Cl.: H01F 10/32, H01F 41/30, G01R 33/028

(54) **AIMANT PERMANENT COMPRENANT UNE COUCHE ANTIFERROMAGNETIQUE ET UNE COUCHE FERROMAGNETIQUE, CAPTEUR COMPRENANT L'AIMANT PERMANENT ET MÉTHODE DE FABRICATION DE L'AIMANT PERMANENT**
DAUERMAGNET UMFASSEND EINE ANTIFERROMAGNETISCHE SCHICHT UND EINE FERROMAGNETISCHE SCHICHT, SENSOR UMFASSEND DEN DAUERMAGNET UND HERSTELLUNGSVERFAHREN DES DAUERMAGNETEN
PERMANENT MAGNET COMPRISING AN ANTIFERROMAGNETIC LAYER AND A FERROMAGNETIC LAYER, SENSOR COMPRISING THE PERMANENT MAGNET AND METHOD OF MANUFACTURING THE PERMANENT MAGNET

(30) Priorité: 10.11.2017 FR 1760619
(43) Date de publication de la demande: 16.09.2020
(73) Titulaire: Commissariat à l'énergie atomique et aux énergies alternatives, 75015 Paris (FR)
(72) Inventeur: HIDA, Rachid, 38210 Cras (FR); DELAET, Bertrand, 38190 Bernin (FR); GIROUD, Sophie, 38120 Saint-Egreve (FR)
(74) Mandataire: INNOV-GROUP
(86) Numéro de dépôt international: PCT/FR2018/052354
(87) Numéro de publication internationale: WO 2019/092333

(56) Documents cités:
- EP-A1- 3 229 036
- DE-A1-102007 032 299
- FR-A1- 2 852 400
- FR-A1- 3 020 497

## Description

L'invention concerne un aimant permanent ainsi qu'un capteur de champ magnétique incorporant cet aimant permanent. L'invention concerne également un procédé de fabrication de cet aimant permanent.

Des capteurs connus de champ magnétique incorporent des aimants permanents pour mesurer l'amplitude, dans une direction donnée, d'un champ magnétique à mesurer. De tels capteurs sont décrits, par exemple, en référence à la figure 4 de la demande US2011/0151589 ou en référence aux figures 1A à 8 de la demande WO2010/0084165. D'autres capteurs sont décrits dans la demande US2017053724A1.

Les aimants permanents utilisés dans ces capteurs, contrairement aux couches piégées (« pinned layer » en anglais) utilisées dans les vannes de spin ou GMR (« Giant Magnetoresistance ») et dans les jonctions tunnels ou TMR (« Tunnel Magnetoresistance »), doivent générer un champ magnétique important. Pour rappel, dans les vannes de spin et les jonctions tunnels, le champ magnétique généré par la couche piégée doit au contraire être faible pour permettre à la direction d'aimantation de la couche libre de tourner et de s'aligner sur la direction d'un champ magnétique extérieur. Ainsi dans le cas de structures dynamiques, comme des structures MRAM (Magnetoresistive Random Access Memory) par exemple, l'aimantation évolue lors de l'utilisation de la structure. Au contraire, dans les aimants permanents, la direction d'aimantation est figée.

Pour obtenir un champ magnétique important, dans les capteurs connus, l'aimant permanent est réalisé par un empilement de couches ferromagnétiques et de couches antiferromagnétiques. Par exemple, un tel aimant permanent connu peut comporter :
- une couche antiferromagnétique,
- une couche ferromagnétique, la direction d'aimantation de la couche ferromagnétique étant figée par un couplage d'échange avec la couche antiferromagnétique, cette couche ferromagnétique comportant :
   - une première sous-couche en contact avec la couche antiferromagnétique ou seulement séparée de la couche antiferromagnétique par une sous-couche ferromagnétique intermédiaire dont l'épaisseur est inférieure à 2 nm, l'épaisseur de cette première sous-couche étant supérieure à 2 nm, cette première sous-couche étant réalisée dans un premier type de matériau ferromagnétique, le premier type de matériau ferromagnétique étant un alliage de fer et de cobalt au moins en partie cristallisé, et
   - une deuxième sous-couche séparée de la couche antiferromagnétique par la première sous-couche, l'épaisseur de cette deuxième sous-couche étant supérieure à 2 nm, cette deuxième sous-couche étant réalisée dans un second type de matériau ferromagnétique.

Un tel aimant permanent connu est décrit dans la demande EP3229036. Dans la demande EP3229036, la deuxième sous-couche est un alliage de fer, de cobalt et de bore de manière à améliorer l'insensibilité de cet aimant aux perturbations magnétiques extérieures. L'aimantation d'un tel aimant permanent, présente typiquement un cycle d'hystérésis tel que celui représenté sur la figure 1 de la demande EP3229036.

Les aimants permanents connus sont sensibles aux traitements thermiques et, en particulier, aux traitements thermiques impliquant des températures élevées. Ici, par température élevée, on désigne une température supérieure à 200°C et, typiquement, supérieure à 300°C ou 400°C. L'aimant permanent est soumis à de tels traitements thermiques notamment au cours de certaines phases de sa fabrication. Par exemple, il n'est pas rare qu'un tel aimant soit exposé à des traitements thermiques impliquant des températures supérieures à 400°C lors de la réalisation de la couche d'encapsulation qui va l'isoler mécaniquement et chimiquement de l'environnement extérieur.

La sensibilité de l'aimant permanent aux traitements thermiques se traduit par une modification définitive de ses propriétés magnétiques et, en particulier, de la forme et/ou de la position de son cycle d'hystérésis. Plus précisément, suite à un traitement thermique à une température élevée, on observe généralement une diminution du ratio Hₑₓ/H_{c}. Les champs H_{c} et Hₑₓ sont définis plus loin. Généralement, aux températures élevées, cette diminution du ratio Hₑₓ/H_{c} est substantielle. Typiquement, cette diminution est substantielle lorsque, en amplitude, elle correspond à une variation d'au moins 10 % ou 30 % de sa valeur initiale, c'est-à-dire de sa valeur avant l'application du traitement thermique.

Il est souhaitable de diminuer cette sensibilité des aimants permanents aux traitements thermiques ou, autrement dit, d'augmenter la stabilité thermique de ces aimants permanents.

L'invention vise à satisfaire ce souhait. A cet effet, l'invention a pour objet un aimant permanent conforme à la revendication 1.

Les modes de réalisation de cet aimant permanent peuvent comporter une ou plusieurs des caractéristiques des revendications dépendantes.

L'invention a également pour objet un capteur de champ magnétique comportant l'aimant revendiqué, tel que défini à la revendication 11.

Enfin, l'invention a également pour objet un procédé de fabrication de l'aimant permanent revendiqué, tel que défini à la revendication 12.

L'invention sera mieux comprise à la lecture de la description qui va suivre, donnée uniquement à titre d'exemple non limitatif tout en se référant aux dessins sur lesquels :
- la figure 1 est une illustration schématique, en vue de dessus, d'un capteur de champ magnétique ;
- la figure 2 est une illustration schématique, en coupe verticale longitudinale, d'un aimant permanent du capteur de la figure 2 ;
- la figure 3 est un organigramme d'un procédé de fabrication de l'aimant permanent de la figure 2 ;
- la figure 4 est une illustration de la diffraction aux rayons X d'un premier et d'un second types de matériaux ferromagnétiques utilisés dans l'aimant de la figure 2,
- les figures 5 et 6 sont des illustrations des cycles d'hystérésis d'aimants permanents réalisés à l'aide d'une couche ferromagnétique constituée seulement du premier ou seulement du second types de matériaux ferromagnétiques décrits en référence à la figure 4 ;
- la figure 7 est une illustration du cycle d'hystérésis d'un aimant permanent réalisé à l'aide d'une couche ferromagnétique comportant une sous-couche de chacun des types de matériaux ferromagnétiques décrits en référence à la figure 4 ;
- les figures 8 à 10 sont des illustrations schématiques, en coupe verticale longitudinale, d'autres modes de réalisation possibles pour des motifs de l'aimant permanent de la figure 2.

### Chapitre I : Notations et définitions :

Dans ces figures, les mêmes références sont utilisées pour désigner les mêmes éléments. Dans la suite de cette description, les caractéristiques et fonctions bien connues de l'homme du métier ne sont pas décrites en détail.

Dans cette description, sauf indication contraire, les proportions sont indiquées en « pourcentage atomique » et notées « % at » ou simplement « % ».

Dans cette description, lorsqu'on indique qu'une couche ou une sous-couche est « réalisé en X » ou lorsqu'on parle d'une « couche X » ou d'une « couche de X » ou d'une « couche en X », on désigne une couche ou une sous-couche dans laquelle la proportion du matériau X représente plus de 95 %, et généralement, plus de 98 % ou 99 %.

Par « alliage de fer et de cobalt », on désigne un alliage dans lequel la proportion de fer et de cobalt est supérieure à 95 % ou 95 % ou 99 %.

Par « alliage de fer et de nickel », on désigne un alliage dans lequel la proportion de fer et de nickel est supérieure à 95 % ou 95 % ou 99 %.

La composition d'une couche ou d'une sous-couche est notée de la façon suivante : AₓB_{y}, où :
- A et B sont les symboles des éléments chimiques composant cette couche ou sous-couche, et
- l'indice x est la proportion de l'élément A dans la couche ou sous-couche, et
- l'indice y est la proportion de l'élément B dans la couche ou sous-couche.

Par la suite, par « aimant permanent », on désigne un aimant permanent dont le champ magnétique est important. Le champ magnétique d'un aimant permanent comportant un empilement de couches ferromagnétiques et antiferromagnétiques est considéré comme important si le moment magnétique total de cet aimant par unité de surface est supérieur à 50 x 10⁻³ A et, de préférence, supérieur à 500 x 10⁻³ A ou 1000 x 10⁻³ A. La méthode de mesure de ce moment magnétique total est par exemple celle décrite dans la demande EP3229036.

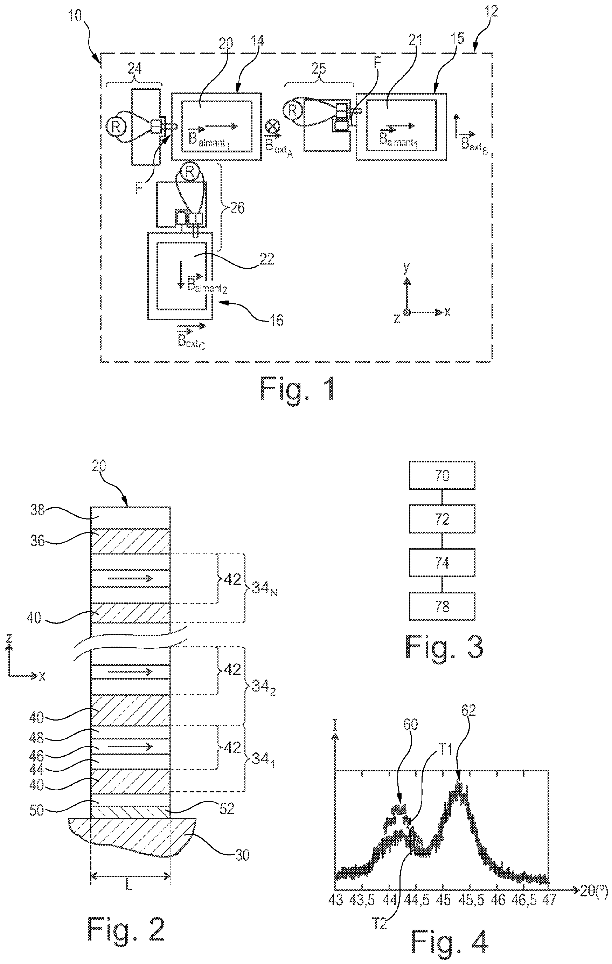

Les termes « champ d'échange Hₑₓ» ou « champ Hₑₓ», « champ coercitif H_{c}» ou « champ H_{c} » et « champ H* » sont déjà définis dans la demande EP3229036. Ici, on utilise la définition de ces termes donnée en regard de la figure 1 de la demande EP3229036.

Le champ B_{R} de l'aimant permanent correspondant à l'aimantation à champ nul.

Le terme « Squareness » ou « rectangularité » désigne une valeur qui est d'autant plus élevé que le cycle d'hystérésis de l'aimant permanent est proche d'un rectangle. Cette valeur est par exemple calculée à l'aide de la formule suivante : Squareness = (1 - (BR / (SlopeAtH_{c} * H_{c}))), où SlopeAtH_{c} est la pente de la courbe de l'aimantation B en fonction du champ H au niveau d'un point d'abscisse Hₑₓ - H_{c}. Il est également renvoyé à la définition de ce terme dans la demande EP3229036.

### Chapitre II : Exemples de modes de réalisation :

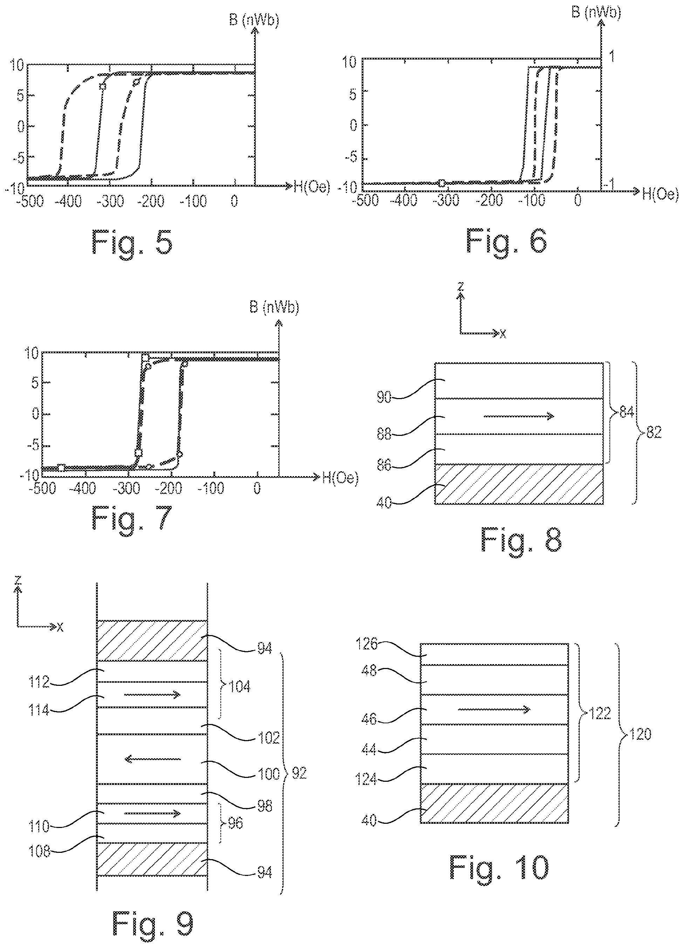

La figure 1 représente un capteur 10 de champ magnétique. Ce capteur 10 est identique au capteur décrit en référence à la figure 8 de la demande US2017053724A1, sauf en ce qui concerne la structure des aimants permanents utilisés. Ainsi, seule une brève description de l'architecture générale de ce capteur est donnée pour illustrer un exemple de réalisation d'un tel capteur.

Ce capteur 10 comprend :
- un substrat 12 s'étendant essentiellement dans un plan horizontal parallèle à des directions orthogonales X et Y, et
- trois magnétomètres 14 à 16 mono-axes réalisés sur le substrat 12.

Une direction Z, perpendiculaire aux directions X et Y, représente la verticale. Par la suite, les figures suivantes sont orientées par rapport à ce même repère X, Y, Z. De plus, les termes tels que « au-dessus », « en dessous », « en bas », « en haut » sont définis par rapport à cette direction Z.

Les magnétomètres 14 à 16 mesurent l'amplitude du champ magnétique à mesurer dans les directions, respectivement, Z, Y et X. A cet effet, chaque magnétomètre 14 à 16 comporte :
- un aimant permanent, respectivement 20 à 22, apte à se déplacer par rapport au substrat 12, et
- un transducteur, respectivement 24 à 26, apte à transformer le déplacement de l'aimant permanent en une variation de courant ou de tension correspondante.

Par exemple, les transducteurs 24 à 26 sont des transducteurs piézorésistifs. Typiquement, ces transducteurs sont fixés, sans degré de liberté, d'un côté sur le substrat 12 et, d'un autre côté, à l'aimant permanent.

Ici, les aimants permanents 20 à 22 sont identiques à l'exception du fait que la direction du moment magnétique globale de l'aimant permanent 22 est perpendiculaire à celle des aimants permanents 20 et 21. Dès lors, seule une description détaillée de l'aimant permanent 20 est donnée par la suite.

La figure 2 représente l'aimant permanent 20 déposé sur un socle 30 mobile par rapport au substrat 12. Par exemple, le socle 30 est obtenu par gravure du substrat 12. Seule une portion de ce socle 30 est représentée sur la figure 2.

L'aimant 20 est formé d'un empilement, dans une direction d'empilement, de couches ferromagnétiques et antiferromagnétiques. Ici, la direction d'empilement est parallèle à la direction Z. Sur la figure 2 et les suivantes, les conventions suivantes sont adoptées :
- les couches antiferromagnétiques sont hachurées,
- la direction du moment magnétique d'une couche ferromagnétique est représentée par une flèche,
- les lignes ondulées au milieu de l'empilement indiquent qu'une portion intermédiaire de cet empilement n'a pas été représentée,
- les proportions entre les épaisseurs des différentes couches ne sont pas respectées pour améliorer la lisibilité des figures, et
- la proportion entre la longueur L et la hauteur de l'empilement n'est pas respectée pour réduire la taille des figures dans la direction longitudinale de l'empilement.

Ici, l'empilement présente une forme parallélépipédique et un facteur de forme supérieur ou égal à 2, 5 ou 20, voire même supérieur à 100 ou 1000. Dans ce mode de réalisation, le facteur de forme est défini comme étant le rapport de la longueur L sur la largeur W de l'empilement. Ici, la longueur est parallèle à la direction X et la largeur W est parallèle à la direction Y.

Plus le facteur de forme est important et plus il est facile d'aligner la direction d'aimantation des couches ferromagnétiques sur la direction longitudinale de l'empilement. Par exemple, la largeur de l'empilement est inférieure à 20 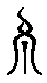 m ou 10 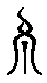 m et la longueur L est supérieure à 50 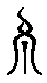 m ou 100 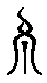 m ou 1 mm. La hauteur de l'empilement est généralement supérieure à 100 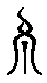 m ou 500 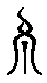 m. Cette hauteur est mesurée entre la couche de l'empilement la plus proche du socle 30 et la couche de ce même empilement la plus éloignée du socle 30.

Ici, l'empilement de couches ferromagnétiques et antiferromagnétiques est composé successivement dans la direction Z :
- d'un motif 34 répété N fois, puis
- d'une couche antiferromagnétique 36 puis, typiquement,
- d'une couche 38 d'encapsulation déposée au sommet de cet empilement.

La couche 38 est destinée à protéger l'aimant permanent des agressions chimiques et/ou physiques de l'environnement extérieur. Cette couche 38 est réalisée dans un matériau non magnétique. Par matériau non magnétique, on désigne ici un matériau dépourvu de propriété magnétique susceptible de perturber le fonctionnement de l'aimant permanent 20. Généralement, il s'agit d'un matériau dont les propriétés magnétiques sont nulles ou non mesurables.

Typiquement, la couche 38 est réalisée en Tantale (Ta) ou en Molybdène (Mo) ou en Ruthénium (Ru) ou une combinaison de ces matériaux. Par exemple, la couche 38 est réalisée en tantale (Ta) et son épaisseur est supérieure ou égale à 10 nm.

La couche 36 est une couche antiferromagnétique. Elle est par exemple identique à la couche 40 décrite plus loin.

La première occurrence du motif 34 dans l'empilement, c'est-à-dire celle qui est la plus proche du socle 30 porte la référence 34₁, la seconde occurrence immédiatement au-dessus de cette première occurrence 34₁ porte la référence 342 et ainsi de suite jusqu'à l'occurrence 34N.

Ici, les occurrences 34₁ à 34_{N} sont directement empilées les unes au-dessus des autres et ne sont donc séparées les unes des autres par aucune autre couche n'appartenant pas au motif 34.

Le nombre N de répétitions du motif 34 est généralement choisi pour atteindre une hauteur souhaitée de l'empilement. Cette hauteur dépend de l'application envisagée. N est supérieur ou égal à 2 et, de préférence, supérieur à 5 ou 10 ou 20. N est également généralement inférieur à 50 ou 100. Ici, N est également choisi de manière à atteindre le moment magnétique par unité de surface recherché pour l'aimant permanent.

Dans ce mode de réalisation, les différentes occurrences du motif 34 sont toutes identiques les unes aux autres et seule l'occurrence 34₁ va donc être décrite en détail.

L'occurrence 34₁ est composée successivement dans la direction Z :
- d'une couche antiferromagnétique 40, et
- d'une couche ferromagnétique 42 dont la direction d'aimantation est piégée par couplage d'échange avec la couche antiferromagnétique 40.

Dans cette demande, par couche « antiferromagnétique » on désigne une couche horizontale d'épaisseur constante dans laquelle la proportion de matériaux antiferromagnétiques est supérieure à 95 % ou 98 % ou 99 %. Par exemple, les matériaux antiferromagnétiques utilisés sont choisis dans le groupe composé :
- des alliages de manganèse, et
- du NiO, et
- du Fe₂O₃.

Les alliages de manganèse antiferromagnétiques sont typiquement le PtMn, NiMn, PdPtMn, FeMn et IrMn. Dans cet exemple, le matériau antiferromagnétique choisi pour la couche 40 est l'alliage PtMn.

Dans cette demande, par couche « ferromagnétique » on désigne une couche horizontale d'épaisseur constante dans laquelle la proportion de matériaux ferromagnétiques est supérieure à 95 % ou 98 % ou 99 %.

Dans ce mode de réalisation, la direction d'aimantation c'est-à-dire la direction du moment magnétique, de la couche 42 est parallèle et de même sens que la direction X. Typiquement, l'amplitude de l'aimantation à saturation de la couche 42 est supérieure ou égale à 397887 A/m ou 795774 A/m ou 1432394 A/m.

Cette direction d'aimantation est piégée par un couplage d'échange avec la couche 40. De plus, dans ce mode de réalisation particulier, la direction d'aimantation de la couche 42 de l'occurrence 34₁ est également piégée par un couplage d'échange avec la couche 40 de l'occurrence 34₂ située immédiatement au-dessus. La direction d'aimantation de la couche 42 de l'occurrence 34N est piégée par couplage d'échange avec la couche 36. Ainsi, la direction d'aimantation de chaque couche 42 est piégée, par couplage d'échange, avec des couches antiferromagnétiques situées, respectivement, immédiatement au-dessous et au-dessus de cette couche 42.

Un couplage d'échange entre une couche ferromagnétique et une couche antiferromagnétique apparaît si :
- la couche ferromagnétique est directement déposée sur la couche antiferromagnétique, ou
- uniquement séparée de la couche antiferromagnétique par une (ou plusieurs) très fine(s) couche(s) non-magnétique(s) dont l'épaisseur totale est inférieure à 0,5 nm et, de préférence, inférieure à 0,4 nm ou 0,2 nm.

Ainsi, dans ce texte, les expressions « une couche ferromagnétique en contact avec la couche antiferromagnétique » ou « une sous-couche ferromagnétique en contact avec la couche antiferromagnétique » désigne aussi bien le cas où la couche ferromagnétique ou la sous-couche ferromagnétique est directement en contact mécanique avec la couche antiferromagnétique que le cas où cette couche ou cette sous-couche est uniquement séparée de la couche antiferromagnétique par une ou des couches non-magnétiques dont l'épaisseur totale est inférieure à 0,5 nm.

Le couplage d'échange entre les couches ferromagnétique et antiferromagnétique est bien connu. Par exemple, le lecteur peut se référer à l'article suivant : J. Nogués et Ivan K. Schuller, « Exchange bias » Journal of magnetism and magnetic materials 192 (1999), 203-232.

La présence du couplage d'échange entre la couche ferromagnétique et la couche antiferromagnétique se traduit notamment par un décalage, par exemple, vers la gauche, du cycle d'hystérésis de l'assemblage de ces deux couches et donc par l'apparition d'un champ Hₑₓ non nul.

Ici, l'épaisseur des couches 40 et 42 sont choisies pour obtenir un bon couplage d'échange entre ces deux couches. Dans cette description, on considère que le couplage d'échange est bon si cela se traduit par l'apparition d'un champ d'échange Hₑₓ dont la valeur absolue est supérieure à 50 Oe (3978 A/m) et, de préférence, supérieure à 100 Oe (7957 A/m) ou 200 Oe (15915 A/m) ou 500 Oe (39788 A/m) à 25°C.

Les champs Hₑₓ et H_{c} d'un empilement comportant seulement les couches 40 et 42 peut être mesuré expérimentalement ou obtenu par simulation numérique.

Un bon couplage d'échange permet en cas de perturbation magnétique extérieure importante de revenir à l'état initial après la disparition de cette perturbation.

L'épaisseur des couches 40 et 42 est, par exemple, déterminée par expérimentation ou par simulation numérique en testant successivement des épaisseurs différentes pour un empilement formé seulement d'une couche antiferromagnétique et d'une couche ferromagnétique réalisées dans les mêmes matériaux que les couches 40 et 42. Pour les matériaux antiferromagnétiques et ferromagnétiques les plus courants, les épaisseurs appropriées sont connues de l'homme du métier. Par exemple, typiquement, l'épaisseur de la couche 40 est comprise entre 5 et 100 nm et, de préférence, entre 5 et 25 nm. L'épaisseur de la couche 42 est souvent comprise entre 5 nm et 100 nm. Dans cet exemple, l'épaisseur de la couche 40 est de préférence comprise entre e42/3 et 3e42 pour obtenir un bon couplage d'échange, où e₄₂ est l'épaisseur de la couche 42. Ici, l'épaisseur de la couche 40 est de 30 nm tandis que l'épaisseur de la couche 42 est de 20 nm.

Le moment magnétique global de l'aimant permanent 20 est proportionnel à la somme des moments magnétiques des couches 42 de l'empilement.

Pour augmenter la stabilité thermique de l'aimant 20, la couche 42 comporte immédiatement empilées les unes sur les autres dans la direction Z :
- une sous-couche 44 réalisée dans un premier type de matériau ferromagnétique,
- une sous-couche 46 réalisée dans un second type de matériau ferromagnétique, et
- une sous-couche 48 réalisée dans le premier type de matériau ferromagnétique.

Par la suite, les premier et second types de matériaux ferromagnétiques sont appelés, respectivement, « matériau T1 » et « matériau T2 ».

Chacune de ces sous-couches 44, 46 et 48 a une épaisseur supérieure à 2 nm ou 4 nm. La sous-couche 46 est directement déposée sur la sous-couche 44 et la sous-couche 48 est directement déposée sur la sous-couche 46. De préférence, l'épaisseur e₄₆ de la sous-couche 46 est supérieure, et de préférence 1,1 fois ou 1,2 fois supérieure, à l'épaisseur e₄₄ de la sous-couche 44. De même, de préférence, l'épaisseur e₄₆ est supérieure, et de préférence 1,1 fois ou 1,2 fois supérieure, à l'épaisseur e₄₈ de la sous-couche 48. Avantageusement, l'épaisseur e₄₆ est supérieure à 5 nm et, si possible, supérieure à e₄₂/2, où e₄₂ est l'épaisseur totale de la couche 42. Avantageusement, les épaisseurs e₄₄ et e₄₈ sont chacune inférieure à e42/3. Ici, à titre d'illustration les épaisseurs e₄₄ et e₄₈ sont égales à 6 nm et l'épaisseur e₄₆ est égale à 8 nm.

Ici, les sous-couches 44 et 48 sont en contact avec les couches 40 respectivement des occurrences 34₁ et 342.

Le matériau T1 présente un fort champ Hₑₓ mais, typiquement, son champ H_{c} est thermiquement instable. Plus précisément, lorsque le matériau T1 subit un traitement thermique, son champ H_{c} augmente. A l'inverse, le matériau T2 présente un champ H_{c} thermiquement stable mais offre un champ Hₑₓ plus faible.

Typiquement, un matériau ferromagnétique dont le champ H_{c} est thermiquement instable est un matériau ferromagnétique pour lequel l'amplitude de son champ H_{c} après avoir subi un traitement thermique à une température élevée Tₘₐₓ, est supérieure ou égale à 1,1H_{cini} ou 1,3H_{cini}, où H_{cini} est la valeur de l'amplitude du champ coercitif de ce même matériau avant de subir pour la première fois ce traitement thermique. Tₘₐₓ est fixé en fonction des traitements thermiques qu'aura à subir l'aimant 20. Ici, Tₘₐₓ est choisi égal à 400°C. Généralement, le traitement thermique à cette température élevée dure plus d'une minute et moins d'une heure. Par exemple, ici le traitement thermique à la température Tₘₐₓ dure 30 min. Un matériau ferromagnétique dont le champ H_{c} est thermiquement stable est un matériau ferromagnétique dont le champ H_{c} n'est pas thermiquement instable.

Ici, les matériaux T1 et T2 sont tous les deux des alliages de fer et de cobalt. Ils se distinguent l'un de l'autre au moins par leur structure cristallographique et, éventuellement en plus, par les proportions de fer et de cobalt. Plus précisément, il a été observé que le matériau T1 présente une proportion P1 de cristaux cubiques à face centrée supérieure à la proportion P2 de cristaux cubiques à face centrée présente dans le matériau T2.

La structure cubique à face centrée est également connu sous l'expression de réseau de Bravais cubique à face centrées et sous l'acronyme fcc (« face-centered cubic »). Il est rappelé qu'un cristal cubique à face centrée présente un atome à chaque sommet du cube et un atome au centre de chaque face du cube. Dans le cas de cristaux cubiques à face centrée d'un alliage de fer et de cobalt, plusieurs structures sont possibles pour ces cristaux cubiques à face centrée. Par exemple, les trois structures suivantes sont possibles :
- Structure a) : les atomes de fer occupent les sommets du cube et les atomes de cobalt occupent le centre de chacune des faces,
- Structure b) : les atomes de fer occupent les sommets du cube et les centres des faces horizontales du cube, les atomes de cobalt occupent le centre de chacune des faces verticales du cube, et
- Structure c) : les atomes de cobalt occupent les sommets du cube et les atomes de fer occupent le centre de chacune des faces.

Ici par « cristaux cubique à face centrée » d'un alliage de fer et de cobalt, on désigne tous les cristaux cubiques à face centrée quelle que soit leur structure.

Ici, les proportions P₁ et P₂ sont des nombres de cristaux cubiques à face centrée par unité de surface ou par unité de volume. Typiquement, la proportion P₁ est 1,1 fois ou 1,3 fois supérieure à la proportion P2.

L'identification et le dénombrement des cristaux cubiques à face centrée dans une sous-couche peuvent être réalisés en observant, par microscopie électronique en transmission, une coupe réalisée dans cette sous-couche. Une telle application de la microscopie électronique en transmission est par exemple décrite dans l'article suivant : S.Groudeva-Zotova and al : « Magnetic and structural characteristics of exchange biasing systems based on NiMn antiferromagnetic films », Journal of Magnetism and Magnetic Materials, Volume 263, Issue 1-2, p. 57-71 (2003). La microscopie électronique en transmission est plus connue sous l'acronyme TEM (« Transmission Electron Microscopy »). Ainsi à partir d'une observation d'une sous-couche par microscopie électronique en transmission, il est possible d'estimer le nombre de cristaux cubiques à face centrée par unité de surface de cette sous-couche et donc la proportion de ces cristaux cubiques à face centrée dans cette sous-couche. D'autres méthodes sont possibles pour estimer la proportion de cristaux cubiques à face centrée dans un matériau ferromagnétique comme par exemple la cristallographie au rayon X plus connue sous l'acronyme XRD (« X-ray Diffraction »).

Ici, dans ce premier mode de réalisation, l'alliage de fer et de cobalt utilisé pour les matériaux T1 et T2 est le Co₈₀Fe₂₀. Les proportions de fer et de cobalt dans les matériaux T1 et T2 sont donc identiques. Toutefois, ils se distinguent l'un de l'autre par leur structure cristallographique. Pour cela, par exemple, les matériaux T1 et T2 sont déposés par pulvérisation (« sputtering » en anglais) dans les mêmes conditions sauf que la vitesse V1 de dépôt du matériau T1 est au moins cinq ou dix fois supérieure à la vitesse V2 de dépôt du matériau T2. Par exemple, la vitesse V2 de dépôt du matériau T2 est supérieure à 0,3 nm/min ou 0,5 nm/min.

Dans l'aimant 20, la première occurrence 34₁ est directement déposée sur une couche 50 de germination ou « seed layer » en anglais. La couche 50 peut être, par exemple, une couche en matériau non-magnétique utilisée pour faciliter le dépôt, par exemple par croissance par épitaxie, de la couche 40. La couche 50 est par exemple une couche de Ruthénium de 3 nm d'épaisseur. Ici, la couche 50 est elle-même directement déposée sur une couche d'accroché 52 ou « Buffer layer » en anglais. La couche 52 est par exemple une couche de Tantale de 5 nm d'épaisseur. La couche 52 est directement déposée sur le socle 30. D'autres variantes sont bien sûr possibles et notamment une unique couche servant à la fois de « seed layer » et de « Buffer layer ».

La figure 3 représente un procédé de fabrication de l'aimant permanent 20. Plus précisément, lors d'une étape 70, les différentes couches et sous-couches décrites en référence à la figure 2 sont déposées les unes sur les autres. Pour cela, on utilise des méthodes connues dans le domaine des microtechnologies et de la réalisation des puces électroniques. Lors de l'étape 70, aucune mise en forme particulière n'est donnée à cet empilement de couches. Cet empilement recouvre au moins les emplacements où doivent être réalisés les aimants 20 à 22.

Ici, lors de l'étape 70, les sous-couches 44, 46 et 48 de chaque couche ferromagnétique 42 sont déposées par pulvérisation. Par exemple, dans ce mode de réalisation, les sous-couches 44, 46 et 48 sont déposées en mettant en œuvre un procédé de pulvérisation par faisceau d'ions plus connu sous l'acronyme IBS (« lon-Beam Sputtering »). Ici, les paramètres de ce procédé de pulvérisation par faisceau d'ions sont réglés pour déposer les sous-couches 44 et 48 à une vitesse V1 cinq ou dix fois supérieure à la vitesse V2 de dépôt de la sous-couche 46. Par exemple, pour le dépôt des sous-couches 44 et 48 la tension de grille, l'intensité du faisceau et la puissance du faisceau sont choisis égaux, respectivement, à 1800 V, 261 mA et 470 W ce qui permet d'obtenir une vitesse V1 de 10 nm de matériau T1 déposé par minute. Pour le dépôt de la sous-couche 46, la tension de grille, l'intensité du faisceau et la puissance du faisceau sont choisis égaux, respectivement, à 600 V, 92 mA et 55 W ce qui permet d'obtenir une vitesse V2 de 1 nm de matériau T2 déposé par minute.

Lors d'une étape 72, cet empilement est structuré pour ne laisser subsister que des empilements en forme de barreau aux emplacements où les aimants 20 à 22 doivent être réalisés. Ainsi, à l'issue de cette étape, il ne subsiste que des barreaux ayant les facteurs de forme requis, c'est-à-dire généralement supérieur à 2, 10 ou 100.

Ensuite, lors d'une étape 74, les barreaux sont chauffés pour que la température des couches antiferromagnétiques dépasse leur température de mise en ordre. Ce recuit est effectué sous champ magnétique saturant comme décrit par exemple dans la demande US 2011/0151589.

Ensuite comme décrit par exemple dans la demande US 2011/0151589, lors d'une étape 78, les barreaux sont refroidis sous un champ plus faible jusqu'à ce que les couplages d'échange entre les couches ferromagnétiques et antiferromagnétiques apparaissent et piègent les directions d'aimantation de chaque couche ferromagnétique. On obtient alors les aimants permanents 20 à 22.

Pour les autres étapes de fabrication du capteur 10, le lecteur peut se référer aux demandes de brevet précédemment citées dans l'introduction.

Le graphique de la figure 4 montre les résultats d'une analyse par cristallographie au rayon X des matériaux T1 et T2 lorsque ces matériaux sont obtenus avec des vitesses de dépôt différentes telles que celles mises en œuvre dans le procédé de la figure 3. Sur ce graphique, l'axe des abscisses représente la direction du rayon X diffracté et l'axe des ordonnées représente l'intensité du rayon X diffracté. Les courbes désignées par les références T1 et T2 correspondent, respectivement, aux matériaux T1 et T2. Les pics désignés par les références 60 et 62 sont caractéristiques de la présence, respectivement, de cristaux cubiques à face centrée et de cristaux cubiques centrés. La structure cubique centrée est également connu sous le terme de réseau de Bravais cubique centré et sous l'acronyme bcc (« body-centered cubic »). Les intensités des pics 60 et 62 sont d'autant plus grandes que les proportions, respectivement, de cristaux cubiques à face centrée et cubiques centrés sont importantes. Cette analyse par cristallographie au rayon X confirme donc que la proportion de cristaux cubiques à face centrée dans le matériau T1 est supérieure à la proportion de ces mêmes cristaux dans le matériau T2. A l'inverse, le graphe de la figure 4 montre que les proportions de cristaux cubiques centrés dans les matériaux T1 et T2 sont identiques. Ainsi, c'est bien spécifiquement la proportion de cristaux cubiques à face centrée qui permet de distinguer les matériaux T1 et T2. Cette analyse a également permis de montrer que les proportions P1 et P2 de cristaux cubiques à face centrée par unité de surface dans les matériaux T1 et T2 sont égales, respectivement, à 76,4 et 48,4 dans le cas particulier de ce mode de réalisation. Les valeurs 76,4 et 48,4 sont exprimées en unité arbitraire et permettent seulement de comparer les concentrations des cristaux cubiques à face centrée dans les matériaux T1 et T2 lorsqu'elles sont mesurées dans les mêmes conditions avec le même appareil.

Différents expériences ont été réalisées pour montrer l'intérêt d'introduire une sous-couche en matériau T1 en contact avec une couche antiferromagnétique et une sous-couche en matériau T2 éloignée des interfaces avec les couches antiferromagnétiques. Plus précisément, pour trois aimants N°1 à 3 différents, les propriétés magnétiques énumérées dans le tableau ci-dessous ont été mesurées, respectivement, avant l'application pour la première fois d'un traitement thermique à 400°C et après l'application de ce traitement thermique. Les résultats expérimentaux obtenus sont résumés dans le tableau ci-dessous.

| N° aimant | Avant le traitement thermique à 400°C | | | | Après le premier traitement thermique à 400°C | | | |
|---|---|---|---|---|---|---|---|---|
| | Hₑₓ (Oe) | H_{c} (Oe) | Jₑₓ ( erg/cm²) | Squareness | Hₑₓ (Oe) | H_{c} (Oe) | Jₑₓ ( erg/cm²) | Squareness |
| 1 | 283 | 52 | 0,41 | 0,9106 | 342 | 72 | 0,49 | 0,8366 |
| 2 | 98 | 25 | 0,14 | 0,9421 | 77 | 23 | 0,11 | 0,8496 |
| 3 | 228 | 46 | 0,33 | 0,9452 | 228 | 46 | 0,33 | 0,9173 |

Dans le tableau ci-dessus, la première colonne comporte le numéro de l'aimant sur lequel les mesures ont été réalisées. Les champs Hₑₓ et H_{c} du tableau sont exprimés en Oersted (Oe). On rappelle que 1 Oe = 1000/(4π) A.m⁻¹. La grandeur Jₑₓ désigne l'amplitude du couplage d'échange. Cette amplitude est décrite en terme d'énergie interfaciale par unité de surface. Cette grandeur est donnée par la relation suivante : Jₑₓ = Mₛe_{F}Hₑₓ, où :
- Jₑₓ est exprimé en erg/cm² (1 erg/cm² = 10⁻³ Joule/m²)
- Mₛ est l'aimantation à saturation exprimée en emu/cm³ (1 emu/cm³ = 10³ A/m),
- e_{F} est l'épaisseur de la couche ferrromagnétique exprimée en centimètre,
- Hₑₓ est le champ d'échange exprimé en Oersted.

Ici, chaque aimant N°1 à 3 a été réalisé en mettant en œuvre le procédé de la figure 3 à l'exception de l'étape 72. Ainsi, les aimants testés ne sont pas structurés et ne s'allongent donc pas dans une direction particulière. Pour simplifier les mesures expérimentales, chaque aimant permanent comporte seulement une occurrence du motif 34. De plus, lors de leur fabrication, après l'étape 74, les aimants n'ont subi aucun traitement thermique à plus de 400°C avant celui qualifié de premier traitement thermique dans le tableau ci-dessus.

Ci-dessous, pour chaque numéro d'aimant, on donne la composition de chaque couche/sous-couche en partant de la couche 52 et en allant jusqu'à la couche 38. Dans les lignes ci-dessous, la composition d'une couche ou sous-couche est séparée de la composition des couches immédiatement précédente et suivante dans l'empilement par le symbole « / ». Le chiffre, qui est séparé de la composition de la couche ou sous-couche par un espace, exprime l'épaisseur de cette couche ou sous-couche en nanomètre. Le symbole T1 ou T2 entre parenthèses après la composition d'une couche ou d'une sous-couche indique s'il s'agit du matériau T1 ou T2.
Aimant N°1 : Ta 5/ Ru 3/ Pt₅₀Mn₅₀ 30/ Co₈₀Fe₂₀ (T1) 20/ Pt₅₀Mn₅₀ 30/ Ta 10
Aimant N°2 : Ta 5/ Ru 3/ Pt₅₀Mn₅₀ 30/ Co₈₀Fe₂₀ (T2) 20/ Pt₅₀Mn₅₀ 30/ Ta 10.
Aimant N°3 : Ta 5/ Ru 3/ Pt₅₀Mn₅₀ 30/ Co₈₀Fe₂₀ (T1) 6/ Co₈₀Fe₂₀ (T2) 8/ Co₈₀Fe₂₀ (T1) 6/ Pt₅₀Mn₅₀ 30/ Ta 10.

Les figures 5 à 7 représentent, pour respectivement les aimants N°1 à 3, les cycles d'hystérésis mesurés avant et après l'application du traitement thermique. Sur ces figures 5 à 7, la ligne en trait plein représente le cycle d'hystérésis mesuré avant l'application du premier traitement thermique à 400°C. La ligne en traits pointillés représente le cycle d'hystérésis mesuré après l'application de ce premier traitement thermique pendant une durée de 30 min. Sur ces figures, l'axe des abscisses représente le champ magnétique exprimée en Oersted. L'axe des ordonnées représente le flux magnétique B. Il est exprimé en nano-Weber (nWb). On rappelle que 1 Wb = 1 T·m².

Les différentes mesures indiquées dans le tableau ont été obtenues à l'aide d'un appareil de mesure connu sous le terme de « BH-Looper ». Ici, il s'agit par exemple de l'appareil MESA-200 commercialisé par la société SHB instruments.

Comme le montre les mesurent indiquées dans le tableau, à quantité de matériaux ferromagnétique et antiferromagnétique identique, la combinaison dans une même couche ferromagnétique de sous-couches en matériaux T1 et T2 permet d'améliorer très nettement la stabilité thermique de l'aimant. En particulier dans l'aimant N°3 :
- le champ Hₑₓ est beaucoup moins dégradé par le traitement thermique que dans le cas où la couche ferromagnétique est uniquement réalisée en matériau T2 (Aimant N°2),
- le champ H_{c} est beaucoup moins dégradé par le traitement thermique que dans le cas où la couche ferromagnétique est uniquement réalisée en matériau T1 (Aimant N°l), et
- la « squareness » est beaucoup moins dégradée par le traitement thermique que dans le cas où la couche ferromagnétique est uniquement réalisée en matériau T1 (Aimant N°1) ou uniquement en matériau T1 (Aimant N°2).

La figure 8 représente un motif 82 apte à remplacer le motif 34 dans l'aimant 20. Le motif 82 est identique au motif 34 sauf que la couche ferromagnétique 42 est remplacée par une couche ferromagnétique 84. La couche 84 est identique à la couche 42 sauf qu'elle est réalisée par l'empilement l'une sur l'autre de trois sous-couches. Plus précisément, elle comporte, directement empilées les unes sur les autres dans la direction Z :
- une sous-couche ferromagnétique 86 en matériau T1,
- une sous-couche ferromagnétique 88 en matériau T2, et
- une sous-couche ferromagnétique 90 en matériau T1.

Ce qui distingue les sous-couches 86 et 90 des sous-couches 44 et 48 précédemment décrites, c'est la composition du matériau T1. En effet, dans ce mode de réalisation, en plus du fait que la proportion de cristaux cubiques à face centrée est plus importante dans le matériau T1 que dans le matériau T2, les proportions de fer et de cobalt ne sont pas les mêmes dans les matériaux T1 et T2. Dans ce cas, typiquement, la proportion de cobalt dans le matériau T1 est supérieure à 60 % et, de préférence, supérieure à 70 % ou 80 %. La proportion de fer dans le matériau T1 est donc inférieure à 40 %. Par exemple, ici le matériau T1 est un alliage Co₈₀Fe₂₀ ou Co₉₀Fe₁₀. A l'inverse, la proportion de cobalt dans le matériau T2 est inférieure à 50 % et, de préférence, inférieure à 40 %. La proportion de fer dans le matériau T2 est donc supérieure à 50 %. Avantageusement, pour le matériau T2, la proportion de fer est comprise entre 60 % et 70 % et la proportion de cobalt est comprise entre 30 % et 40 %. Par exemple, ici le matériau T2 est l'alliage Fe₆₅Co₃₅ déposé comme précédemment décrit pour obtenir un matériau T2. On notera que dans ce mode de réalisation, la vitesse V1 de dépôt n'a pas besoin d'être au moins cinq fois supérieure à la vitesse V2 de dépôt du matériau T2. En effet, la différence de composition du matériau T1 suffit à elle-seule pour que la proportion de cristaux cubiques à face centrée dans le matériau T1 soit supérieure à celle dans le matériau T2 et cela même si la vitesse V1 n'est pas cinq fois supérieure à la vitesse V2. Par exemple, la vitesse V1 peut dans ce cas être égale à la vitesse V2.

Lorsque la direction d'aimantation d'une couche ferromagnétique d'un motif est piégée par couplage d'échange avec une seule couche antiferromagnétique, alors, de préférence, cette couche ferromagnétique comporte seulement une sous-couche en matériau T1 en contact avec cette couche antiferromagnétique. Il n'est pas nécessaire, voire inutile, que cette couche ferromagnétique comporte une autre sous-couche en matériau T1 située ailleurs qu'au niveau de l'interface avec la couche antiferromagnétique. Ceci est illustré à l'aide du motif 92 de la figure 9. Le motif 92 est apte à remplacer le motif 34 dans l'aimant 20. Le motif 92 est identique au motif 34 décrit dans la demande US2017053724A1 sauf en ce qui concerne la structure des couches ferromagnétiques en contact avec les couches antiferromagnétiques. La structure du motif 92 est donc seulement brièvement rappelée ici. Pour plus de détail, le lecteur est renvoyé à la demande US2017053724A1. Le motif 92 comporte successivement en partant du bas vers le haut :
- une couche antiferromagnétique 94,
- une couche ferromagnétique 96 dont la direction d'aimantation est piégée par couplage d'échange avec la couche antiferromagnétique 94,
- une couche 98 non-magnétique connue sous le terme de « espaceur » ou « spacer » en anglais,
- une couche ferromagnétique 100 dont la direction d'aimantation est piégée par couplage RKKY (Ruderman-Kittel-Kasuya-Yosida) antiferromagnétique avec la couche ferromagnétique 96,
- une couche 102 non-magnétique formant un espaceur, et
- une couche ferromagnétique 104 dont la direction d'aimantation est piégée par couplage d'échange avec la couche antiferromagnétique 94 de l'occurrence du motif 92 situé juste au-dessus dans l'empilement de motifs.

La couche 96 comporte seulement une sous-couche 108 en matériau T1 et une sous-couche 110 en matériau T2. La sous-couche 108 est en contact avec la couche antiferromagnétique 94. La sous-couche 110 est directement déposée sur la sous-couche 108. De façon correspondante, la couche ferromagnétique 104 comporte :
- une sous-couche 112 en matériau T1 en contact avec la couche antiferromagnétique située immédiatement au-dessus de la couche ferromagnétique 104, et
- une sous-couche 114 en matériau T2 située du côté opposé à la couche antiferromagnétique qui fige la direction d'aimantation de la couche 104.

Dans le motif 90, les matériaux T1 et T2 sont réalisés, par exemple, comme décrit dans les modes de réalisation précédents.

La figure 10 représente un motif 120 apte à remplacer le motif 34 dans l'aimant 20. Le motif 120 est identique au motif 34 sauf que la couche ferromagnétique 42 est remplacée par une couche ferromagnétique 122. La couche 122 est identique à la couche 42 sauf qu'elle comporte :
- une sous-couche 124 interposée entre la sous-couche 44 et la couche antiferromagnétique 40, et
- une sous-couche 126 interposée entre la sous-couche 48 et la couche antiferromagnétique 40 située immédiatement au-dessus.

Les sous-couches 124 et 126 sont réalisées en alliage NiFe. De préférence, la proportion de nickel dans cet alliage est supérieure à 60 % et la proportion de fer est inférieure à 40 %. Les épaisseurs des sous-couches 124 et 126 sont inférieures à 2 nm et, de préférence, inférieures à 1 nm. Typiquement, les épaisseurs des sous-couches 124, 126 sont supérieures à 0,5 nm. La présence de ces sous-couches 124, 126 permet d'améliorer l'amplitude du champ Hₑₓ. Dans ce mode de réalisation les sous-couches en matériau T1 ne sont pas en contact avec les couches antiferromagnétiques.

### Chapitre III : Variantes

### Variantes des motifs :

De nombreux autres modes de réalisation de la couche ferromagnétique sont possibles. Par exemple, la couche ferromagnétique peut comporter plusieurs sous-couches en matériau T2 directement empilées les unes sur les autres au lieu d'une seule sous-couche en matériau T2. De façon similaire, la sous-couche en matériau T1 peut être remplacée par un empilement directement les unes sur les autres de plusieurs sous-couches en matériau T1.

Dans une autre variante, des sous-couches supplémentaires dans des matériaux ferromagnétiques autres que les matériaux T1 et T2, peuvent être introduites dans la couche ferromagnétique. Par exemple, il est possible d'introduire au-dessus de la sous-couche 110 ou entre les sous-couches 44 et 46 ou encore entre les sous-couches 46 et 48, une fine couche en alliage CoFeB. Par fine couche, on désigne ici une couche dont l'épaisseur est inférieure à 1 nm et, généralement, supérieure à 0,5 nm.

Les épaisseurs des sous-couches en matériaux T1 et T2 peuvent être modifiées de façon assez importante sans que cela ne remettent en cause l'amélioration de la stabilité thermique obtenue. Par exemple, dans le cas du motif 34 ou 82, les épaisseurs suivantes sont également possibles :
- e₄₄ = 2,5 nm, e₄₆ = 15 nm, e₄₈ = 2,5 nm,
- e₄₄ = 5 nm, e₄₆ = 10 nm, e₄₈ = 5 nm, ou
- e₄₄ = 7,5 nm, e₄₆ = 5 nm, e₄₈ = 7,5 nm,

En variante, dans tous les modes de réalisation, l'alliage CoFe utilisé pour réaliser le matériau T1 peut être remplacé par un alliage NiFe. De préférence, l'alliage NiFe utilisé comporte une proportion de nickel supérieure à 60 % et une proportion de fer inférieure à 40 %.

La couche antiferromagnétique 40 peut elle aussi être formée d'un empilement de plusieurs sous-couches antiferromagnétiques. Par exemple, la couche antiferromagnétique est formée d'une sous-couche en IrMn directement déposée sur une sous-couche en PtMn.

La couche antiferromagnétique 36 déposée sur la couche ferromagnétique du dernier motif de l'empilement peut être omise. Dans ce cas, de préférence, l'épaisseur de la couche 42 de ce dernier motif est réduite par rapport à l'épaisseur de la couche 42 des autres motifs du même empilement.

### Variantes de l'empilement :

D'autres structures sont possibles pour le motif. Par exemple, l'enseignement donné dans cette demande s'applique aux différents motifs décrits dans les figures 6 à 8 de la demande US2017053724A1.

Il est également possible de combiner, dans un même empilement, des motifs différents. Par exemple, il est possible de construire un empilement en alternant les motifs 34 et 82 ou les motifs 34 et 92 ou les motifs 84 et 122 ou autres.

Dans un mode de réalisation simplifié, la couche ferromagnétique comportant les sous-couches en matériaux T1 et T2 est uniquement introduite dans une partie seulement des motifs de l'empilement. Ainsi, au moins un motif, et de préférence au moins 40 % ou 50 % ou 80 % des motifs de cet empilement, comportent une telle couche ferromagnétique.

De façon similaire, le matériau antiferromagnétique utilisé pour former la couche 40 d'un motif peut être différent d'un motif à l'autre. Par exemple, dans un motif, ce matériau antiferromagnétique est de l'IrMn et dans un autre motif, il s'agit du PtMn.

La couche d'accroché 52 peut être omise.

L'ordre des couches antiferromagnétique et ferromagnétique à l'intérieur des motifs peut être inversé. Dans ce cas, la couche ferromagnétique est située sous la couche antiferromagnétique.

### Autres variantes :

Il existe d'autres procédés de dépôt par pulvérisation susceptibles d'être utilisés à la place du dépôt par pulvérisation par faisceau d'ions. Par exemple, le dépôt par pulvérisation cathodique magnétron ou le dépôt par pulvérisation cathodique triode, connu sous l'acronyme PCT, ou d'autres méthodes de pulvérisations cathodiques peuvent être mises en œuvre. Quel que soit le procédé de pulvérisation utilisés le rapport entre les vitesses de dépôt des matériaux T1 et T2 sont ajustés comme décrit précédemment, si nécessaire, pour obtenir les matériaux T1 et T2.

L'empilement n'a pas nécessairement une forme parallélépipédique. Par exemple, la section de l'empilement parallèlement aux directions X, Y est une ellipse ou un ovale. Dans ces derniers cas, le facteur de forme de l'aimant permanent est défini comme étant le rapport de la longueur sur la largeur du parallélépipède de plus petit volume contenant entièrement l'empilement.

En variante, le facteur de forme de l'empilement n'est pas nécessairement supérieur ou égal à deux. Par exemple, il peut être égal à un.

### Chapitre IV : Avantages des modes de réalisation

L'utilisation de sous-couches en matériaux T1 et T2 permet d'augmenter la stabilité thermique de l'aimant permanent notamment vis-à-vis des traitements thermiques à température élevée.

L'utilisation de sous-couches en matériaux T1 et T2 dans lesquels les proportions de fer et de cobalt sont identiques, simplifie la fabrication de la couche ferromagnétique.

Le fait de faire varier la proportion de fer et de cobalt pour obtenir les matériaux T1 et T2 permet de ne pas nécessairement jouer sur la vitesse de dépôt pour obtenir ces deux types de matériaux.

Le fait de répéter le motif au moins deux fois dans la direction d'empilement permet d'obtenir un champ magnétique plus important.

Utiliser la vitesse de dépôt pour obtenir les sous-couches en matériaux T1 et T2 simplifie la fabrication de l'aimant permanent.

## Revendications

1. Aimant permanent comprenant :
- une couche antiferromagnétique (40 ; 94),
- une couche ferromagnétique (42 ; 84 ; 96, 104; 122), la direction d'aimantation de la couche ferromagnétique étant figée par un couplage d'échange avec la couche antiferromagnétique, cette couche ferromagnétique comportant :
• une première sous-couche (44, 48 ; 86, 90 ; 108, 112) en contact avec la couche antiferromagnétique ou seulement séparée de la couche antiferromagnétique par une sous-couche ferromagnétique intermédiaire (124, 126) dont l'épaisseur est inférieure à 2 nm, l'épaisseur de cette première sous-couche étant supérieure à 2 nm, cette première sous-couche étant réalisée dans un premier type de matériau ferromagnétique, le premier type de matériau ferromagnétique étant un alliage de fer et de cobalt au moins en partie cristallisé, et
• une deuxième sous-couche (46 ; 88 ; 110, 114) séparée de la couche antiferromagnétique par la première sous-couche, l'épaisseur de cette deuxième sous-couche étant supérieure à 2 nm, cette deuxième sous-couche étant réalisée dans un second type de matériau ferromagnétique,
**caractérisé en ce que** le second type de matériau ferromagnétique est aussi un alliage de fer et de cobalt dans lequel la proportion de cristaux cubiques à face centrée est inférieure à la proportion de cristaux cubiques à face centrée dans le premier type de matériau ferromagnétique.

2. Aimant selon la revendication 1, dans lequel :
- la proportion, en pourcentage atomique, de fer dans le premier type de matériau est égale à la proportion, en pourcentage atomique, de fer dans le deuxième type de matériau, et
- la proportion, en pourcentage atomique, de cobalt dans le premier type de matériau est égale à la proportion, en pourcentage atomique, de cobalt dans le deuxième type de matériau.

3. Aimant selon la revendication 2, dans lequel :
- la première sous-couche (44, 48) est obtenue à l'aide d'un procédé de dépôt par pulvérisation, et
- la deuxième sous-couche (46) est obtenue à l'aide du même procédé de dépôt par pulvérisation mais configuré pour obtenir une vitesse de dépôt de la deuxième sous-couche cinq fois plus petite que la vitesse de dépôt de la première sous-couche.

4. Aimant selon la revendication 1, dans lequel :
- dans le premier type de matériau, les proportions, en pourcentage atomique, de fer et de cobalt sont, respectivement, inférieure à 40 % et supérieure à 60 %, et
- dans le second type de matériau, les proportions, en pourcentage atomique, de fer et de cobalt sont, respectivement, supérieure à 50 % et inférieure à 50 %.

5. Aimant selon l'une quelconque des revendications précédentes, dans lequel les proportions, en pourcentage atomique, de fer et de cobalt dans le second type de matériau sont égales, respectivement à x % et y %, où x est compris entre 60 et 70 et y est compris entre 30 et 40.

6. Aimant selon l'une quelconque des revendications précédentes, dans lequel :
- l'aimant permanent comporte un empilement de N motifs (34 ; 82 ; 92 ; 120) empilés immédiatement les uns sur les autres dans une direction d'empilement, où N est un nombre entier supérieur ou égal à deux, chaque motif comportant :
- un exemplaire de ladite couche antiferromagnétique réalisée en matériau antiferromagnétique,
- un exemplaire de ladite couche ferromagnétique réalisée en matériau ferromagnétique et dont la direction d'aimantation est figée par couplage d'échange avec l'exemplaire de ladite couche antiferromagnétique de ce motif
- les directions d'aimantation des différents exemplaires de la couche ferromagnétique de tous les motifs étant toutes identiques les unes aux autres.

7. Aimant selon la revendication 6, dans lequel :
- la direction d'aimantation de l'exemplaire de ladite couche ferromagnétique de N-1 motifs est également figée par un couplage d'échange avec l'exemplaire de ladite couche antiferromagnétique d'un motif immédiatement adjacent dans l'empilement, et
- chaque exemplaire de ladite couche ferromagnétique dans chacun de ces N-1 motifs comporte un troisième sous-couche (48 ; 90) en contact avec l'exemplaire de la couche antiferromagnétique du motif adjacent ou seulement séparée de cet exemplaire de ladite couche antiferromagnétique du motif adjacent par une sous-couche intermédiaire en matériau ferromagnétique dont l'épaisseur est inférieure à 2 nm, la deuxième sous-couche (46 ; 88) étant interposée entre les première et troisième sous-couches (44, 48 ; 86, 90), l'épaisseur de cette troisième sous-couche étant supérieure à 2 nm, et la troisième sous-couche étant réalisée dans le premier type de matériau ferromagnétique.

8. Aimant selon la revendication 6 ou 7, dans lequel N est un nombre entier supérieur ou égal à cinq ou dix.

9. Aimant selon l'une quelconque des revendications précédentes, dans lequel la proportion de cristaux cubiques à face centrée dans le premier type de matériau ferromagnétique est 1,1 fois supérieure à la proportion de cristaux cubiques à face centrée dans le second type de matériau ferromagnétique.

10. Aimant selon l'une quelconque des revendications précédentes, dans lequel l'épaisseur de la sous-couche intermédiaire (124, 126) en matériau ferromagnétique est inférieure à 1 nm.

11. Capteur de champ magnétique comportant :
- un substrat (12) s'étendant essentiellement dans un plan appelé « plan du substrat »,
- au moins un aimant (20-22) permanent déplaçable par rapport au substrat en réponse à une variation de l'amplitude ou de la direction d'un champ magnétique à mesurer,
- un transducteur (24-25) fixé sur le substrat, apte à convertir un déplacement de l'aimant permanent en une grandeur électrique représentative de l'amplitude ou de la direction du champ magnétique à mesurer,
**caractérisé en ce que** l'aimant permanent est conforme à l'une quelconque des revendications précédentes.

12. Procédé de fabrication d'un aimant permanent conforme à l'une quelconque des revendications 1 à 10, ce procédé comportant la formation (70) d'un empilement comportant, empilés l'un sur l'autre dans une direction d'empilement, :
- une couche antiferromagnétique, et
- une couche ferromagnétique comportant :
• une première sous-couche en contact avec la couche antiferromagnétique ou séparée de la couche antiferromagnétique par une sous-couche intermédiaire en matériau ferromagnétique dont l'épaisseur est inférieure à 2 nm, l'épaisseur de cette première sous-couche étant supérieure à 2 nm, cette première sous-couche étant réalisée dans un premier type de matériau ferromagnétique, le premier type de matériau ferromagnétique étant un alliage de fer et de cobalt au moins en partie cristallisé, et
• une deuxième sous-couche séparée de la couche antiferromagnétique par la première sous-couche, l'épaisseur de cette deuxième sous-couche étant supérieure à 2 nm, cette deuxième sous-couche étant réalisée dans un second type de matériau ferromagnétique,
**caractérisé en ce que** le second type de matériau ferromagnétique est aussi un alliage de fer et de cobalt dans lequel la proportion de cristaux cubiques à face centrée est inférieure à la proportion de cristaux cubiques à face centrée dans le premier type de matériau ferromagnétique.

13. Procédé selon la revendication 12, dans lequel l'étape de formation de l'empilement comporte :
- le dépôt de la première sous-couche à l'aide d'un procédé de dépôt par pulvérisation, et
- le dépôt de la deuxième sous-couche à l'aide du même procédé de dépôt par pulvérisation mais configuré pour obtenir une vitesse de dépôt de la deuxième sous-couche cinq fois plus petite que la vitesse de dépôt de la première sous-couche.

## Patentansprüche

1. Permanentmagnet, der Folgendes umfasst:
- eine antiferromagnetische Schicht (40; 94),
- eine ferromagnetische Schicht (42; 84; 96, 104; 122), wobei die Magnetisierungsrichtung der ferromagnetischen Schicht durch eine Austauschkopplung mit der antiferromagnetischen Schicht festgelegt ist, wobei diese ferromagnetische Schicht Folgendes enthält:
• eine erste Unterschicht (44, 48; 86, 90; 108, 112), die mit der antiferromagnetischen Schicht in Kontakt ist oder von der antiferromagnetischen Schicht lediglich durch eine ferromagnetische Zwischen-Unterschicht (124, 126), deren Dicke kleiner als 2 nm ist, getrennt ist, wobei die Dicke dieser ersten Unterschicht größer als 2 nm ist, wobei diese erste Unterschicht aus einem ersten Typ eines ferromagnetischen Materials hergestellt ist, wobei der erste Typ eines ferromagnetischen Materials eine zumindest teilweise kristallisierte Eisen- und Kobaltlegierung ist, und
• eine zweite Unterschicht (46; 88; 110, 114), die von der antiferromagnetischen Schicht durch die erste Unterschicht getrennt ist, wobei die Dicke dieser zweiten Unterschicht größer als 2 nm ist, wobei diese zweite Unterschicht aus einem zweiten Typ eines ferromagnetischen Materials hergestellt ist,
**dadurch gekennzeichnet, dass** der zweite Typ eines ferromagnetischen Materials ebenfalls eine Eisen- und Kobaltlegierung ist, in der der Anteil kubisch flächenzentrierter Kristalle kleiner als der Anteil kubisch flächenzentrierter Kristalle in dem ersten Typ eines ferromagnetischen Materials ist.

2. Magnet nach Anspruch 1, wobei:
- der Atomprozent-Anteil von Eisen in dem ersten Materialtyp gleich dem Atomprozent-Anteil von Eisen in dem zweiten Materialtyp ist und
- der Atomprozent-Anteil von Kobalt in dem ersten Materialtyp gleich dem Atomprozent-Anteil von Kobalt in dem zweiten Materialtyp ist.

3. Magnet nach Anspruch 2, wobei:
- die erste Unterschicht (44, 48) mithilfe eines Zerstäubungsablagerungsverfahrens erhalten wird und
- die zweite Unterschicht (46) mithilfe desselben Zerstäubungsablagerungsverfahrens erhalten wird, das jedoch so konfiguriert ist, dass eine Abscheidungsgeschwindigkeit der zweiten Unterschicht, die fünfmal kleiner als die Abscheidungsgeschwindigkeit der ersten Unterschicht ist, erhalten wird.

4. Magnet nach Anspruch 1, wobei:
- in dem ersten Materialtyp die Atomprozent-Anteile von Eisen und von Kobalt kleiner als 40 % bzw. größer als 60 % sind und
- in dem zweiten Materialtyp die Atomprozent-Anteile von Eisen und von Kobalt größer als 50 % bzw. kleiner als 50 % sind.

5. Magnet nach einem der vorhergehenden Ansprüche, wobei die Atomprozent-Anteile von Eisen und von Kobalt in dem zweiten Materialtyp gleich x % bzw. y % sind, wobei x im Bereich von 60 bis 70 liegt und y im Bereich von 30 bis 40 liegt.

6. Magnet nach einem der vorhergehenden Ansprüche, wobei:
- der Permanentmagnet einen Stapel von N Mustern (34; 82; 92; 120) aufweist, die in einer Stapelrichtung direkt übereinander gestapelt sind, wobei N eine ganze Zahl größer oder gleich zwei ist, wobei jedes Muster Folgendes umfasst:
- ein Exemplar der antiferromagnetischen Schicht, die aus einem antiferromagnetischen Material hergestellt ist,
- ein Exemplar der ferromagnetischen Schicht, die aus einem ferromagnetischen Material hergestellt ist und deren Magnetisierungsrichtung durch Austauschkopplung mit dem Exemplar der antiferromagnetischen Schicht dieses Musters festgelegt ist,
- wobei alle Magnetisierungsrichtungen der verschiedenen Exemplare der ferromagnetischen Schicht sämtlicher Muster identisch sind.

7. Magnet nach Anspruch 6, wobei:
- die Magnetisierungsrichtung des Exemplars der ferromagnetischen Schicht von N
- 1 Mustern auch durch eine Austauschkopplung mit dem Exemplar der antiferromagnetischen Schicht eines in dem Stapel direkt benachbarten Musters festgelegt ist und
- jedes Exemplar der ferromagnetischen Schicht in jeder dieser N - 1 Muster eine dritte Unterschicht (48; 90) aufweist, die in Kontakt mit dem Exemplar der antiferromagnetischen Schicht des benachbarten Musters ist oder von diesem Exemplar der antiferromagnetischen Schicht des benachbarten Musters lediglich durch eine Zwischen-Unterschicht aus einem ferromagnetischen Material, deren Dicke kleiner als 2 nm ist, getrennt ist, wobei die zweite Unterschicht (46; 88) zwischen die erste und die dritte Unterschicht (44, 48; 86, 90) eingefügt ist, wobei die Dicke dieser dritten Unterschicht größer als 2 nm ist und wobei die dritte Unterschicht aus dem ersten Typ eines ferromagnetischen Materials hergestellt ist.

8. Magnet nach Anspruch 6 oder 7, wobei N eine ganze Zahl größer oder gleich fünf oder zehn ist.

9. Magnet nach einem der vorhergehenden Ansprüche, wobei der Anteil kubisch flächenzentrierter Kristalle in dem ersten Typ eines ferromagnetischen Materials 1,1 mal größer als der Anteil kubisch flächenzentrierter Kristalle in dem zweiten Typ eines ferromagnetischen Materials ist.

10. Magnet nach einem der vorhergehenden Ansprüche, wobei die Dicke der Zwischen-Unterschicht (124, 126) aus einem ferromagnetischen Material kleiner als 1 nm ist.

11. Magnetfeldsensor, der Folgendes umfasst:
- ein Substrat (12), das sich im Wesentlichen in einer Ebene, die "Substratebene" genannt wird, erstreckt,
- wenigstens einen Permanentmagneten (20-22), der in Bezug auf das Substrat in Reaktion auf eine Änderung der Amplitude oder der Richtung eines zu messenden Magnetfeldes verlagerbar ist,
- einen Messwandler (24-25), der auf dem Substrat befestigt ist und eine Verlagerung des Permanentmagneten in eine elektrische Größe, die die Amplitude oder die Richtung des zu messenden Magnetfeldes angibt, umsetzen kann,
**dadurch gekennzeichnet, dass** der Permanentmagnet ein Permanentmagnet nach einem der vorhergehenden Ansprüche ist.

12. Verfahren zum Herstellen eines Permanentmagneten nach einem der Ansprüche 1 bis 10, wobei dieses Verfahren das Bilden (70) eines Stapels umfasst, der in einer Stapelrichtung übereinander gestapelt Folgendes umfasst:
- eine antiferromagnetische Schicht und
- eine ferromagnetische Schicht, die Folgendes umfasst:
• eine erste Unterschicht, die mit der antiferromagnetischen Schicht in Kontakt ist oder von der antiferromagnetischen Schicht nur durch eine Zwischen-Unterschicht aus einem ferromagnetischen Material, deren Dicke kleiner als 2 nm ist, getrennt ist, wobei die Dicke dieser ersten Unterschicht größer als 2 nm ist, wobei diese erste Unterschicht aus einem ersten Typ eines ferromagnetischen Materials hergestellt ist, wobei der erste Typ eines ferromagnetischen Materials eine zumindest teilweise kristallisierte Eisen- und Kobaltlegierung ist, und
• eine zweite Unterschicht, die von der antiferromagnetischen Schicht durch die erste Unterschicht getrennt ist, wobei die Dicke dieser zweiten Unterschicht größer als 2 nm ist, wobei diese zweite Unterschicht aus einem zweiten Typ eines ferromagnetischen Materials hergestellt ist,
**dadurch gekennzeichnet, dass** der zweite Typ eines ferromagnetischen Materials ebenfalls eine Eisen- und Kobaltlegierung ist, in der der Anteil kubisch flächenzentrierter Kristalle kleiner als der Anteil kubisch flächenzentrierter Kristalle in dem ersten Typ eines ferromagnetischen Materials ist.

13. Verfahren nach Anspruch 12, wobei der Schritt des Bildens des Stapels Folgendes umfasst:
- Abscheiden der ersten Unterschicht mithilfe eines Zerstäubungsablagerungsverfahrens und
- Abscheiden der zweiten Unterschicht mithilfe desselben Zerstäubungsablagerungsverfahrens, das jedoch so konfiguriert ist, dass eine Abscheidungsgeschwindigkeit der zweiten Unterschicht, die fünfmal kleiner als die Abscheidungsgeschwindigkeit der ersten Unterschicht ist, erhalten wird.

## Claims

1. Permanent magnet comprising:
- an antiferromagnetic layer (40; 94),
- a ferromagnetic layer (42; 84; 96, 104; 122), the magnetization direction of the ferromagnetic layer being set by exchange coupling to the antiferromagnetic layer, this ferromagnetic layer comprising:
• a first sublayer (44, 48; 86, 90; 108, 112) making contact with the antiferromagnetic layer or solely separated from the antiferromagnetic layer by an intermediate ferromagnetic sublayer (124, 126) the thickness of which is smaller than 2 nm, the thickness of this first sublayer being larger than 2 nm, this first sublayer being made of a first type of ferromagnetic material, the first type of ferromagnetic material being an alloy of iron and of cobalt that is at least partially crystallized, and
• a second sublayer (46; 88; 110, 114) separated from the antiferromagnetic layer by the first sublayer, the thickness of this second sublayer being larger than 2 nm, this second sublayer being made of a second type of ferromagnetic material,
**characterized in that** the second type of ferromagnetic material is also an alloy of iron and of cobalt in which the proportion of face-centered cubic crystals is lower than the proportion of face-centered cubic crystals in the first type of ferromagnetic material.

2. Magnet according to Claim 1, wherein:
- the proportion, in atomic percent, of iron in the first type of material is equal to the proportion, in atomic percent, of iron in the second type of material, and
- the proportion, in atomic percent, of cobalt in the first type of material is equal to the proportion, in atomic percent, of cobalt in the second type of material.

3. Magnet according to Claim 2, wherein:
- the first sublayer (44, 48) is obtained using a sputtering deposition process, and
- the second sublayer (46) is obtained using the same sputtering deposition process but configured to obtain a deposition rate for the second sublayer five times lower than the deposition rate of the first sublayer.

4. Magnet according to Claim 1, wherein:
- in the first type of material, the proportions, in atomic percent, of iron and of cobalt are lower than 40% and higher than 60%, respectively, and
- in the second type of material, the proportions, in atomic percent, of iron and of cobalt are higher than 50% and lower than 50%, respectively.

5. Magnet according to any one of the preceding claims, wherein the proportions, in atomic percent, of iron and of cobalt in the second type of material are equal to x% and y%, respectively, where x is comprised between 60 and 70 and y is comprised between 30 and 40.

6. Magnet according to any one of the preceding claims, wherein:
- the permanent magnet comprises a stack of N patterns (34; 82; 92; 120) stacked immediately on one another in a stacking direction, where N is an integer number higher than or equal to 2, each pattern comprising:
- an example of said antiferromagnetic layer made of antiferromagnetic material,
- an example of said ferromagnetic layer made of ferromagnetic material and the magnetization direction of which is set by exchange coupling to the example of said antiferromagnetic layer of this pattern
- the magnetization directions of the various examples of the ferromagnetic layer of all the patterns all being identical to one another.

7. Magnet according to Claim 6, wherein:
- the magnetization direction of the example of said ferromagnetic layer of N-1 patterns is also set by exchange coupling to the example of said antiferromagnetic layer of a pattern immediately adjacent in the stack, and
- each example of said ferromagnetic layer in each of these N-1 patterns comprises a third sublayer (48; 90) making contact with the example of the antiferromagnetic layer of the adjacent pattern or solely separated from this example of said antiferromagnetic layer of the adjacent pattern by an intermediate sublayer made of ferromagnetic material the thickness of which is smaller than 2 nm, the second sublayer (46; 88) being interposed between the first and third sublayers (44, 48; 86, 90), the thickness of this third sublayer being larger than 2 nm, and the third sublayer being made of the first type of ferromagnetic material.

8. Magnet according to Claim 6 or 7, wherein N is an integer number higher than or equal to five or ten.

9. Magnet according to any one of the preceding claims, wherein the proportion of face-centered cubic crystals in the first type of ferromagnetic material is 1.1 times higher than the proportion of face-centered cubic crystals in the second type of ferromagnetic material.

10. Magnet according to any one of the preceding claims, wherein the thickness of the intermediate sublayer (124, 126) made of ferromagnetic material is smaller than 1 nm.

11. Magnetic-field sensor comprising:
- a substrate (12) lying essentially in a plane called the "plane of the substrate",
- at least one permanent magnet (20-22), which is movable with respect to the substrate in response to a variation in the amplitude or in the direction of a magnetic field to be measured,
- a transducer (24-25) fastened to the substrate, which is able to convert a movement of the permanent magnet into an electrical quantity representative of the amplitude or of the direction of the magnetic field to be measured,
**characterized in that** the permanent magnet is according to any one of the preceding claims.

12. Process for manufacturing a permanent magnet according to any one of Claims 1 to 10, this process comprising forming (70) a stack comprising, stacked on one another in a stacking direction:
- an antiferromagnetic layer, and
- a ferromagnetic layer comprising:
• a first sublayer making contact with the antiferromagnetic layer or separated from the antiferromagnetic layer by an intermediate sublayer made of ferromagnetic material the thickness of which is smaller than 2 nm, the thickness of this first sublayer being larger than 2 nm, this first sublayer being made of a first type of ferromagnetic material, the first type of ferromagnetic material being an alloy of iron and of cobalt that is at least partially crystallized, and
• a second sublayer separated from the antiferromagnetic layer by the first sublayer, the thickness of this second sublayer being larger than 2 nm, this second sublayer being made of a second type of ferromagnetic material,
**characterized in that** the second type of ferromagnetic material is also an alloy of iron and of cobalt in which the proportion of face-centered cubic crystals is lower than the proportion of face-centered cubic crystals in the first type of ferromagnetic material.

13. Process according to Claim 12, wherein the step of forming the stack comprises:
- depositing the first sublayer using a sputtering deposition process, and
- depositing the second sublayer using the same sputtering deposition process but configured to obtain a deposition rate for the second sublayer five times lower than the deposition rate of the first sublayer.
